# EUROPÄISCHE PATENTANMELDUNG

(11) **EP 4 421 520 A1**
(43) Veröffentlichungstag der Anmeldung: **28.08.2024**
(21) Anmeldenummer: 23158536.5
(22) Anmeldetag: 24.02.2023
(51) Int. Cl.: G01S 7/40, G01R 31/308, G01S 13/88, G01S 17/88, H02H 5/00, G01S 7/497

(54) **VERSCHMUTZUNGSERKENNUNG BEI ELEKTRISCHEN BAUGRUPPEN MITTELS RADAR-TECHNOLOGIE**

(71) Anmelder: Siemens Aktiengesellschaft, 80333 München (DE)
(72) Erfinder: Zettner, Jürgen, 90587 Veitsbronn (DE)
(74) Vertreter: Siemens Patent Attorneys

(57) **Zusammenfassung**

Die Erfindung betrifft ein Verfahren zum Überprüfen einer elektrischen Baugruppe (10, 21) auf Verschmutzung mittels eines Radars (1, 25) sowie ein Radar (1, 25), wobei eine Radarsignalerzeugungseinrichtung ein Radarsignal (29) erzeugt und mittels einer Radarsignalsendeeinrichtung in Richtung einer von der elektrischen Baugruppe (10, 21) umfassten Oberfläche aussendet, wobei das Radarsignal (29) an der Oberfläche oder einem auf der Oberfläche befindlichen Objekt reflektiert wird, wobei eine Radarsignalempfangseinrichtung ein reflektiertes Radarsignal (32) empfängt und wobei eine Radarsignalauswerteeinrichtung das von der Radarsignalempfangseinrichtung empfangene, reflektierte Radarsignal (32) auswertet zum Erkennen einer bei der elektrischen Baugruppe (10, 21) vorliegenden Verschmutzung.

## Beschreibung

Die Erfindung betrifft ein Verfahren zum Überprüfen einer elektrischen Baugruppe auf Verschmutzung. Ferner betrifft die Erfindung eine Vorrichtung zum Überprüfen einer elektrischen Baugruppe auf Verschmutzung.

Verschmutzung auf elektrischen Baugruppen stellt insbesondere in staubigen Umgebungen, wie sie in der Zementindustrie, im Bergbau etc. vorkommen, aber auch in vielen anderen industriellen Umgebungen ein Problem dar. Auch im maritimen Umfeld können Rückstände zu Schäden führen.

Besonders problematisch sind leitfähige Ablagerungen wie Ruß oder Salz, die insbesondere Kurzschlüsse bei elektrischen, insbesondere elektronischen Baugruppen auslösen können.

Generell führen starke Verschmutzungen zu elektrischen Problemen wie Kriechstrecken oder Störungen bei hochohmigen Signalpfaden sowie thermischen Problemen (schlechtere Entwärmung), die bis hin zum Ausfall elektrischer Baugruppen und damit oftmals ganzer Geräte führen können.

Häufig sind Verschmutzungen in geschlossenen Gehäusen nur schwer bzw. mit hohem Aufwand zu erkennen, z.B. durch:
Optische Inspektion - jedoch aufwendig und in der Regel nicht im Betrieb möglich. Das Gerät muss dazu geöffnet werden.
Indirekt über eine steigende Bauteiltemperatur - ein derartiges Monitoring ist nicht überall möglich und liefert auch nur ein Indiz. Eine erhöhte Bauteiltemperatur kann auch betriebsbedingte Ursachen haben.
Zusätzliche Sensorik zur Detektion von Ablagerungen, z.B. optisch, resistiv oder kapazitiv auf einer Platine - diese benötigt Platz, deckt nicht die gesamte Baugruppe ab und insb. bei Hochvoltbaugruppen ist eine aufwendige Potentialtrennung nötig.

Es ist ferner bekannt, die Auswirkungen von Verschmutzung durch *"*conformal coating*"* oder *"*Verguss*"* zu reduzieren.

Die Patentschrift DE 10 2004 018 578 B4 beschreibt eine Messung der Oberflächenleitfähigkeit zur Erfassung des Verschmutzungsgrades einer elektronischen Baugruppe. Diese Vorgehensweise ist stark von der Art und insbesondere der Leitfähigkeit der Schmutzpartikel abhängig und daher häufig nicht zielführend.

Aus der Veröffentlichung Pohl, Nils & Jaeschke, Timo & Scherr, Steffen & Ayhan, Serdal & Pauli, M. & Zwick, Thomas & Musch, Thomas: "Radar measurements with micrometer accuracy and nanometer stability using an ultra-wideband 80 GHz radar system", 31-33. 10.1109/WiSNet.2013.6488624, ist ein hochpräzises 80-GHz-Radar Entfernungsmesssystem bekannt. Dieses basiert auf einem ultra-breitbandigen monostatischen SiGe-Transceiver-Chip, der eine Bandbreite von 25,6 GHz um eine Mittenfrequenz von 80 GHz (d.h. 32%) ermöglicht. Alle Komponenten außer dem Silizium-Radarchip sind handelsübliche Elektronik, so dass der Sensor gut für kostengünstige industrielle Messanwendungen geeignet ist.

Kommerziell weit verbreitet und damit kostengünstig sind Radar-ICs z.B. im Automotive-Bereich, insbesondere bei Einparkhilfen.

Begünstigt durch höhere Integration einzelner Baugruppen können komplette Radargeräte (nachfolgend auch kurz als *"*Radar*"* bezeichnet) heute als kleinste Module bzw. Integrierte Schaltungen (ICs) aufgebaut werden.

Eine Aufgabe der vorliegenden Erfindung ist es, die Verschmutzungserkennung bei elektrischen Baugruppen zu vereinfachen und zu verbessern.

Diese Aufgabe wird gelöst durch ein Verfahren mit den in Patentanspruch 1 angegebenen Verfahrensschritten, also durch ein Verfahren zum Überprüfen einer elektrischen Baugruppe auf Verschmutzung mittels eines Radars, wobei
- eine Radarsignalerzeugungseinrichtung ein Radarsignal erzeugt und mittels einer Radarsignalsendeeinrichtung in Richtung einer von der elektrischen Baugruppe umfassten Oberfläche aussendet,
- wobei das Radarsignal an der Oberfläche oder einem auf der Oberfläche befindlichen Objekt reflektiert wird,
- wobei eine Radarsignalempfangseinrichtung ein reflektiertes Radarsignal empfängt und wobei
- eine Radarsignalauswerteeinrichtung das von der Radarsignalempfangseinrichtung empfangene, reflektierte Radarsignal auswertet zum Erkennen einer bei der elektrischen Baugruppe vorliegenden Verschmutzung.

Das Grundprinzip der Radar-Technik (Funkmesstechnik) ist seit langem bekannt: eine Radarsignalerzeugungseinrichtung, insbesondere ein (digitaler) Signalprozessor, erzeugt ein (zunächst elektrisches) (Radar-) Signal. Eine Radarsignalsendeeinrichtung und insbesondere wenigstens eine davon umfasste Sendeantenne strahlt dieses in Form eines elektromagnetischen (HF-) Radarsignals (Sendesignals) in Richtung eines Objekts, z.B. eines Fahrzeuges, eines Flugzeuges oder eines Schiffes. Das Objekt reflektiert das gesendete Sendesignal und eine Radarsignalempfangseinrichtung (Radarempfänger bzw. Empfangseinheit) erfasst das von dem Objekt reflektierte Radarsignal (Empfangssignal). Hierbei umfasst die Radarsignalempfangseinrichtung wenigstens eine Empfangsantenne. Als Sende- bzw. Empfangsantenne(n) kann auch dieselbe Antenne bzw. können auch dieselben Antennen verwendet werden, die somit sowohl das Sendesignal aussenden als auch das reflektierte Empfangssignal empfangen. Eine Radarsignalauswerteeinrichtung (Auswerteelektronik), insbesondere ein (digitaler) Signalprozessor, wertet schließlich das empfangene Signal (Empfangssignal bzw. Echo) aus. Insbesondere werden die Laufzeit zwischen dem gesendeten Signal (Sendesignal) und dem empfangenen Echo (Empfangssignal) und die Signalstärke des Echos, gegebenenfalls auch die Phasenlage der beiden Signale gemessen. So ist es möglich, über eine bestimmte Entfernung zu dem Objekt und insbesondere *"*drahtlos*"* eine Reihe an Eigenschaften des Objekts zu erfassen bzw. zu bestimmen, wie z.B. seine Entfernung zum Radar, seine Größe, seine Geschwindigkeit relativ zu dem Radar, seine Oberflächenbeschaffenheit etc.

Erfindungsgemäß wird das oben skizzierte Grundprinzip nun dazu verwendet, um Verschmutzungen an elektrischen (insbesondere elektronischen) Baugruppen zu erkennen.

Insbesondere nutzt ein erfindungsgemäßer *"*Verschmutzungssensor*"* die Eigenschaft von Millimeter-Radarwellen, welche an leitfähigen Stoffen gut reflektiert werden und an dicken organischen Stoffen oder Wasser - mit der Dicke korreliert - absorbiert werden.

Unter einer elektrischen Baugruppe ist im Zusammenhang mit der Erfindung insbesondere jedes elektrische Gerät (z.B. ein elektrischer Motor, ein Umrichter etc.) oder jeder Teil eines elektrischen Gerätes zu verstehen, der eine Einheit bildet, z.B. eine Platine, ein Netzteil etc. Insbesondere ist darunter auch eine elektronische Baugruppe zu verstehen, also eine Ansammlung elektronischer Bauelemente (Dioden, Transistoren, ICs etc.), die zur Erfüllung eines bestimmten Zwecks (Stromversorgung, Datenverarbeitung etc.) miteinander verschaltet sind.

Da Radargeräte preiswert und in kleiner Bauform (z.B. Radar-ICs) am Markt verfügbar sind, lassen sich erfindungsgemäß elektrische Baugruppen einfach und kostengünstig hinsichtlich Verschmutzung überwachen. Allgemein werden so sich auf der Oberfläche der elektrischen Baugruppen ansammelnde und möglicherweise Störungen verursachende Objekte, insbesondere Verunreinigungen bzw. Schmutz jeglicher Form (fest, staubartig, körnig, flüssig etc.), erkannt.

Die von dem Radargerät erzeugten Signale bzw. Daten lassen sich vorzugsweise vorteilhaft aus dem Radargerät auslesen und weiterleiten zur weiteren Datenverarbeitung in einer Recheneinrichtung. Die Recheneinrichtung kann dabei von dem zu überwachenden Gerät umfasst sein, es kann sich aber auch um eine aus Sicht des Gerätes externe Recheneinrichtung handeln. So kann der Grad der Verschmutzung beispielsweise über einen längeren Zeitraum beobachtet und ggf. angemessen darauf reagiert werden, z.B. indem frühzeitig eine Warnmeldung vor einem drohenden Ausfall der elektrischen Baugruppe wegen Verschmutzung erzeugt wird.

Die Signalauswertung zum Erkennen von Schmutz bzw. Verschmutzung kann jedoch auch in dem Radargerät selbst erfolgen. Es verfügt dazu über eine geeignete Rechen- bzw. Datenverarbeitungseinrichtung, auch als Auswerteelektronik bezeichnet, insbesondere einen (digitalen) Signalprozessor.

Eine Ausführungsform der Erfindung sieht vor, dass mittels der Auswerteelektronik ein Vergleich mit Referenzdaten der unverschmutzten Oberfläche der elektrischen Baugruppe erfolgt. Dazu werden insbesondere die von dem Radargerät erzeugten Daten bei der Inbetriebnahme des zu diesem Zeitpunkt unverschmutzten Gerätes gespeichert, so dass Referenzdaten bezüglich der *"*sauberen*"* zu überwachenden elektrischen Baugruppe vorhanden sind.

Aus dem Vergleich der aktuellen Daten mit den entsprechend zuvor erzeugten Referenzdaten kann schnell und zuverlässig eine Veränderung registriert und darauf reagiert werden. Auch lassen sich mittels Aufzeichnung der erzeugten Daten über einen längeren Zeitraum darauf aufbauend Prognosen für die Zukunft erstellen und ggf. frühzeitig darauf reagieren.

Insbesondere aus dem Vergleich mit Messungen an der unverschmutzten elektrischen Baugruppe lassen sich so Erkenntnisse über den Umfang und die Art der Verschmutzung gewinnen.

Weiterhin lässt sich anhand des Vergleichs mit Referenzdaten vorteilhaft auch die Dicke einer detektierten Schmutzschicht ermitteln.

Bezüglich des Typs des verwendeten Radars bestehen prinzipiell keine Einschränkungen. In Frage kommen jedoch vor allem als UWB-Radar (Ultra-Breitband- bzw. engl. ultra-widebandradar), mm- bzw. HF-Radar oder als Infrarot-Radar ausgebildete Varianten, da diese als zuverlässige und kostengünstige Geräte und insbesondere in kleiner Bauform am Markt vorhanden sind. Der spezielle, jeweils zur Anwendung kommende Gerätetyp kann auch abhängig von der Art der zu erwartenden Verschmutzung und dem verfügbaren Bauraum ausgewählt werden.

Insbesondere bei Verwendung eines UWB- (ultra wideband-) Radars mit einer Auflösung im Sub-Millimeter-Bereich lassen sich so bereits geringfügige Verschmutzungen an Bauteil-Oberflächen feststellen.

Vorteilhaft arbeitet die Sende- und Empfängereinheit mit einer Frequenz des gesendeten Signals von mindestens 60GHz, wobei das zu überwachende, verschmutzungsanfällige Bauteil mit Millimeter-Wellen bestrahlt wird und die zurückreflektierte HF-Strahlung mittels einer oder mehrerer (Empfangs-) Antennen empfangen und die frequenzabhängige Signalstärke und/oder deren Phasenlage ausgewertet werden.

Unter Auswertung von Phasenlagen sind damit sogar Auflösungen im Mikrometer-Bereich erzielbar.

Radar-ICs, die im mm-HF Wellenlängenbereich arbeiten, besitzen sowohl eine gute Ortsauflösung (über z.B. 4 integrierte Antennen), als auch einen gewissen *"*durchstimmbaren*"* Frequenzumfang, so dass mit einem derartigen Sensor sowohl eine Lokalisierung einer Verschmutzung möglich ist, als auch eine frequenzabhängige HF-Feldstärke ausgewertet werden kann, welche z.B. für gewisse Verschmutzungsstoffe charakteristisch ist, so dass eine Eingrenzung der Art bzw. Zusammensetzung der Verschmutzung (*"*Fingerprint*"*) erfolgen kann.

Die einzelnen Komponenten des Radargerätes (Radars), also die Radarsignalerzeugungseinrichtung, die Radarsignalsendeeinrichtung, die Radarsignalempfangseinrichtung, die Sende- und/oder Empfangsantenne(n) und die Radarsignalauswerteeinrichtung, mitunter auch als Sende- und Empfangseinheit, Antennen und Auswerteelektronik bezeichnet, können als einzelne, diskrete Bauteile ausgebildet bzw. aus einzelnen, diskreten, miteinander verbundenen Bauteilen aufgebaut sein.

Aufgrund der zunehmenden Miniaturisierung in der Mikroelektronik ist es möglich, viele, vorzugsweise alle notwendigen Komponenten eines Radars in einem einzigen, kleinen Modul zu vereinen, welches beispielsweise direkt auf einer Platine einer elektrischen Baugruppe platziert werden kann. Darüber hinaus ist es möglich, mehrere, insbesondere alle Komponenten des Radargerätes in einem einzigen hochintegrierten Schaltkreis (IC) zu vereinen. Selbst die Integration der Antennen in den IC ist möglich.

Das Radargerät ist somit vorzugsweise einstückig ausgebildet oder es umfasst nur einige wenige Komponenten. Es bedarf daher auch nur einiger weniger Anschlüsse, z.B. zur Spannungsversorgung. Es lässt sich damit schnell und einfach an der dafür vorgesehenen Stelle, beispielsweise auf einer Platine oder in bzw. an einem Gehäuse eines Gerätes, platzieren.

Eine Ausführungsform der Erfindung sieht vor, dass sich das Radar nicht auf der zu überwachenden elektrischen Baugruppe selbst, sondern entfernt von der zu überwachenden elektrischen Baugruppe befindet. Das Radar ist demnach bei dieser Ausführungsform nicht von der zu überwachenden elektrischen Baugruppe umfasst. Insbesondere kann sich das Radar beispielsweise auf einer weiteren elektrischen Baugruppe des Gerätes, welches hinsichtlich Verschmutzung überwacht wird, oder an oder in einem die elektrische Baugruppe umgebenden Gehäuse bzw. Schaltschrank befinden. Die zu überwachende elektrische Baugruppe und das Radar werden jedoch vorzugsweise in geringem Abstand zueinander angeordnet, beispielsweise innerhalb desselben Gehäuses.

Diese Ausführungsform hat den Vorteil, dass das Radar an einer vor Verschmutzung weniger gefährdeten Stelle des Gerätes mit der zu überwachenden elektrischen Baugruppe angebracht werden kann und damit selbst besser vor Verschmutzung geschützt ist.

Eine andere Ausführungsform der Erfindung sieht vor, dass das Radar von der elektrischen Baugruppe umfasst ist. Das Radar befindet sich somit direkt auf oder an der zu überwachenden elektrischen Baugruppe, insbesondere einer zu überwachenden Platine mit weiteren elektrischen und/oder elektronischen Bauteilen. Das Radar bildet in diesem Falle also eine (vorzugsweise vollständige bzw. einteilige bzw. *"*geschlossene*"*) Baugruppe, die auf bzw. an der zu untersuchenden elektrischen Baugruppe angeordnet wird und damit selbst Teil der zu untersuchenden elektrischen Baugruppe ist.

Insbesondere wird das Radar gezielt in einem vor Verschmutzung stark gefährdeten Bereich der elektrischen Baugruppe angeordnet.

Insbesondere umfasst das Radar ein Gehäuse mit einem bezüglich des erzeugten Radarsignals durchlässigen (z.B. transparenten) Gehäusebereich. Vorzugsweise wird das Radar oder zumindest der Gehäusebereich bewusst in einem vor Verschmutzung gefährdeten Bereich der elektrischen Baugruppe angeordnet.

Bei dieser Ausführungsform detektiert das Radar somit, ob bzw. wie stark es selbst von Verschmutzung betroffen ist, indem die Verschmutzung der Gehäuseoberfläche des Radars detektiert wird. Die Ergebnisse dieser Auswertung lassen sich dann zumindest auf Komponenten der elektrischen Baugruppe in der Umgebung des Radars übertragen.

Diese Ausführungsform hat den Vorteil, dass damit die Oberfläche, deren Verschmutzung gemessen wird, und insbesondere deren Eigenschaften (Rauheit, Reflexionsvermögen bzgl. der verwendeten Radarstrahlung etc.) exakt bekannt sind und bei der Signalauswertung berücksichtigt werden können.

In beiden beschriebenen Möglichkeiten der Anordnung des Radars (in einem von Verschmutzung betroffenen Bereich oder abseits davon) stellt sich bei Vorliegen einer nicht unerheblich dicken oder einer ausreichend leitfähigen Verschmutzung eine Änderung des Empfangssignals gegenüber dem Sendesignal, insbesondere einer Signalstärke eines empfangenen Millimeter-HF-Signals ein.

Eine leitfähige Belegung wird in der Regel das empfangene Signal (gegenüber einem Referenz-Objekt ohne Belegung) kaum abschwächen, während eine nichtleitfähige, nicht unerheblich dicke Belegung einer Komponente der elektrischen Baugruppe zu einer Absorption, also starken Abschwächung des Signals gegenüber dem Signal ohne Verschmutzung führt.

Die Möglichkeit der Unterscheidung zwischen leitfähiger und nicht-leitfähiger Verschmutzung ist wichtig, da eine nichtleitfähige Verschmutzung in elektrischen Baugruppen häufig in hohen Dicken vorhanden sein darf, zumindest so lange, bis erheblicher Einfluss auf die Wärmeabfuhr zu verzeichnen ist.

Elektrisch leitfähige Belegungen hingegen sind in der Regel schon bei geringen Belegungen (Belegungen geringer Dicke) unerwünscht, da sie das Risiko von Kurzschlüssen und Durchschlägen erheblich steigern und so sogar Ausfälle der betroffenen elektrischen Baugruppen hervorrufen können.

Neben der Radartechnik kann das verwendete Radargerät zum Erkennen von Verschmutzungen auch auf weitere (Sensor-) Techniken zurückgreifen, um die Art bzw. Zusammensetzung der betreffenden Verschmutzung genauer eingrenzen zu können. Insbesondere weist das Radargerät vorteilhaft Mittel zum Messen eines elektrischen Widerstandes an der Oberfläche des Radars auf, insbesondere mehrere voneinander beabstandete Elektroden, zwischen denen eine elektrische Spannung angelegt und dadurch mittels Strommessern (Amperemeter) der elektrische Widerstand zwischen den Elektroden gemessen werden kann. Dadurch ist es möglich, elektrisch leitfähige Verschmutzungen, die in der Regel als besonders kritisch anzusehen sind, noch sicherer zu detektieren, als dies bei alleiniger Anwendung der Radartechnik der Fall wäre.

Erfindungsgemäß wird vorzugsweise entweder ein in sich geschlossener integrierten Radar-IC mit mindestens 60GHz (Sende- und Empfangseinrichtung) mit einer Oberfläche als Referenzfläche, die der Verschmutzung unterliegt, auf einer Platine einer zu überwachenden elektrischen Baugruppe, z.B. einem Umrichter, platziert oder man platziert den Radar-IC vorteilhaft derart, dass die zu überwachende verschmutzungsanfällige Platine mit Millimeter-Wellen bestrahlt wird und die zurückreflektierte HF-Strahlung mittels einer oder mehrerer Antennen empfangen und die frequenzabhängige Signalstärke des reflektierten Radarsignals und/oder dessen Phasenlage (in Bezug auf das gesendete Radarsignal) ausgewertet wird. Unter Auswertung von Phasenlagen sind heute bereits Mikrometer-Auflösungen erzielbar.

In beiden Aufbauvarianten stellt sich bei Vorliegen einer erheblich dicken oder einer ausreichend leitfähigen Verschmutzung (Belegung) eine Änderung der empfangenen Millimeter-HF-Signalstärke ein. Bei einer leitfähigen Belegung wird in der Regel das empfangene (reflektierte) Radarsignal kaum abgeschwächt, während eine nichtleitfähige, dicke Belegung zu einer Absorption, also starken Abschwächung gegenüber dem Signal ohne Verschmutzung führt. Nicht leitfähige Verschmutzungen dürfen in elektrischen Baugruppen häufig in hohen Dicken vorhanden sein, zumindest so lange, bis erheblicher Einfluss auf die Wärmeabfuhr zu verzeichnen ist.

Elektrisch leitfähige Belegungen sind hingegen in der Regel schon bei geringen Belegungen unerwünscht, da sie das Risiko von Kurzschlüssen und Durchschlägen erheblich steigern.

Radar-ICs, die im mm-HF Wellenlängenbereich arbeiten, besitzen sowohl eine grobe Ortsauflösung (über z.B. 4 integrierte Antennen), als auch einen gewissen durchstimmbaren Frequenzumfang, so dass mit der erfindungsgemäßen Radar-Anwendung sowohl eine grobe Lokalisierung möglich ist als auch eine frequenzabhängige HF-Feldstärke ausgewertet werden kann, welche z.B. für gewisse Verschmutzungsstoffe charakteristisch ist (*"*Fingerprint*"*), so dass eine Eingrenzung der Art der Verschmutzung erfolgen kann.

Die Vorteile der Erfindung liegen insbesondere bei der berührungslosen, potentialgetrennten Erfassung von leitfähigen Verschmutzungen.

Weitere Vorteile der Erfindung sind:
- Durch die berührungslose Messung entfällt - insbesondere bei Hochvoltbaugruppen - eine aufwendige Potentialtrennung;
- Radar-ICs sind robust gegen Umwelteinflüsse und können nichtleitfähige Materialen gut durchstrahlen. Durch den großen Unterschied hinsichtlich der Signalstärke der reflektierten Strahlung kann im Allgemeinen einfach zwischen leitfähigen und nicht leitfähigen Ablagerungen unterschieden werden. Radar-ICs können so auch zur Stoffdetektion (Fingerprint) verwendet werden;
- Die Erfindung ermöglicht ein Online-Monitoring im laufenden Betrieb einer hinsichtlich Verschmutzung zu überprüfenden elektrischen Baugruppe;
- Die Stoffcharakteristik und damit die Zusammensetzung unterschiedlicher Verschmutzungen ist ermittelbar;
- Ein abgeleitetes Maß mit Korrelation zur Leitfähigkeit und/oder der Dicke der Verschmutzung ist ermittelbar.

Die Erfindung wird nachfolgend anhand von Ausführungsbespielen exemplarisch näher beschrieben und erläutert. Dabei zeigen:
- FIG 1: ein erstes Ausführungsbeispiel zur Überwachung einer elektrischen Baugruppe mittels eines Radars,
- FIG 2: ein zweites Ausführungsbeispiel zur Überwachung einer elektrischen Baugruppe mittels eines Radars,
- FIG 3: Verfahrensschritte bei der Durchführung eines erfindungsgemäßen Verfahrens.

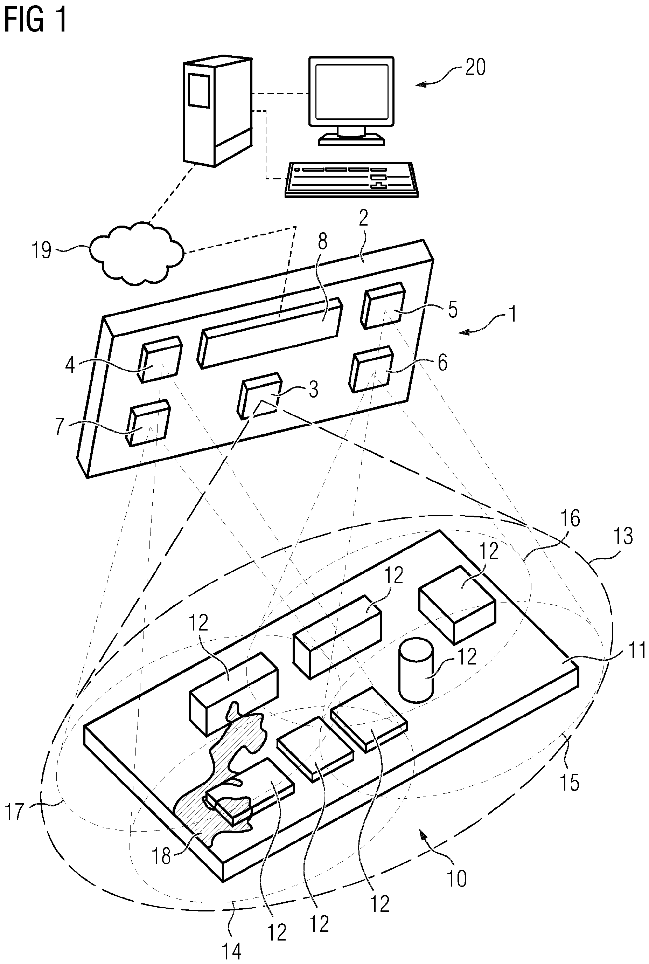

FIG 1 zeigt eine elektrische Baugruppe 10 in Form einer mit mehreren elektrischen und elektronischen Bauelementen 12 bestückten Platine 11. Die elektrische Baugruppe 10 befindet sich in einer vor Verschmutzung gefährdeten Umgebung, z.B. in einer industriellen Umgebung der Zement- oder chemischen Industrie.

Erfindungsgemäß wird die elektrische Baugruppe 10 durch ein Radargerät (Radar) 1 bezüglich Verschmutzung überwacht. Dabei sind auf einem Modulträger, z.B. einer Platine 2 des Radars 1, alle wesentlichen Komponenten des Radars 1 angebracht. Zu diesen Komponenten zählen: eine Sendeantenne 3, vier Empfangsantennen 4-7 sowie ein Signalprozessor 8. Der Signalprozessor 8 umfasst in einem IC integriert wenigstens teilweise eine Radarsignalerzeugungseinrichtung, eine Radarsignalsendeeinrichtung (Radarsender), eine Radarsignalempfangseinrichtung (Radarempfänger) sowie eine Radarsignalauswerteeinrichtung (Auswerteelektronik). Dabei kann die Sendeantenne 3 der Radarsignalsendeeinrichtung und können die Empfangsantennen 4-7 der Radarsignalempfangseinrichtung zugeordnet sein.

Es ist auch möglich, dass alle gezeigten bzw. genannten Komponenten des Radars 1 in einem einzigen Radar-IC (nicht dargestellt) integriert sind.

Die Radarsignalerzeugungseinrichtung erzeugt im Ausführungsbeispiel ein mm-HF-Radarsignal, welches über den Radarsender und insbesondere die davon umfasste Sendeantenne 3 in Richtung der elektrischen Baugruppe 10 gesendet wird. Vorteilhaft wird der räumliche Sendebereich 13 dabei so gewählt, dass er die elektrische Baugruppe 10 vollständig abdeckt, das Sendesignal also alle Bereiche der elektrischen Baugruppe 10 erreicht. An der elektrischen Baugruppe 10 bzw. deren Komponenten 11 und 12 wird das Sendesignal reflektiert und als Echo bzw. Empfangssignal von den vier Empfangsantennen 4-7 des Radars 1 erfasst.

Jeder der vier Empfangsantennen 4-7 ist ein Bereich 14-17 der Oberfläche der elektrischen Baugruppe 10 zugeordnet, so dass sich ggf. der Bereich der Oberfläche der elektrischen Baugruppe 10, der von Verschmutzung betroffen ist, enger eingrenzen lässt. Im Ausführungsbeispiel wird dadurch erkannt, dass in dem der Empfangsantenne 4 zugeordneten Bereich 14 der elektrischen Baugruppe 10 Schmutzpartikel 18 vorhanden sind und somit in diesem Bereich eine Verschmutzung vorliegt.

Zum Erkennen einer Verschmutzung werden die von den Empfangsantennen 14-17 erfassten Empfangssignale - gegebenenfalls nach einer Signalumwandlung und/oder -aufbereitung in der Radarsignalempfangseinrichtung - analysiert. Insbesondere erfolgt dabei ein Vergleich mit in der Radarsignalauswerteeinrichtung hinterlegten, bezüglich der unverschmutzten elektrischen Baugruppe 10 erzeugten Empfangssignale bzw. Daten.

Im Ausführungsbeispiel gemäß FIG 1 ist das Radar 1 entfernt von der zu überwachenden elektrischen Baugruppe 10 angeordnet, also nicht an oder auf der zu überwachenden elektrischen Baugruppe, und ist vorzugsweise so platziert, insbesondere an oder in einem die elektrische Baugruppe 10 umgebenden Gehäuse (nicht dargestellt), dass es selbst in einem vor Verschmutzung weniger gefährdeten bzw. geschützten Bereich liegt.

Die Erfindung ist insbesondere dann von Vorteil, wenn ein Benutzer der elektrischen Baugruppe 10 rechtzeitig vor einer Verschmutzung gewarnt wird, bevor diese Schaden an der elektrischen Baugruppe 10 anrichtet, zum Beispiel in Form möglicher Kurzschlüsse oder Überhitzung. Dafür ist das Radar 1 im Ausführungsbeispiel über eine Datenverbindung, zum Beispiel das Internet 19, mit einer externen Recheneinrichtung, im Ausführungsbeispiel einem PC 20 verbunden. In dem PC 20 können die von dem Radar 1 erzeugten Daten empfangen, gespeichert und gegebenenfalls weiterverarbeitet werden. Insbesondere kann so die Verschmutzung der elektrischen Baugruppe 10 über einen längeren Zeitraum (zum Beispiel Jahre) registriert und analysiert werden. Vorteilhaft kann so ab einem bestimmten erkannten Maß an Verschmutzung eine Warnmeldung an einen Benutzer der elektrischen Baugruppe 10 abgegeben werden. Vorteilhaft wird dieser so rechtzeitig vor einem drohenden Ausfall der elektrischen Baugruppe 10 gewarnt, bevor dieser eintritt.

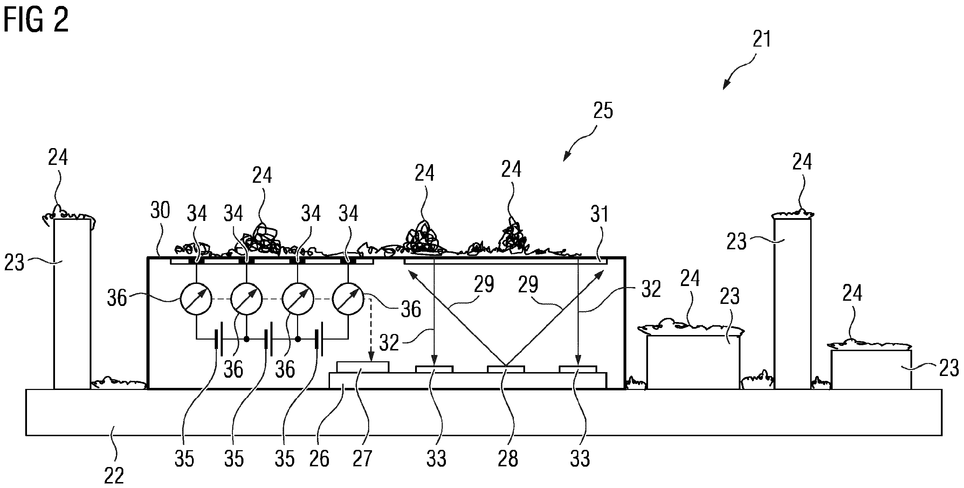

FIG 2 zeigt ein weiteres Ausführungsbeispiel der Erfindung. Auch hier wird eine elektrische Baugruppe 21 mittels eines Radars 25 auf Verschmutzung überwacht. Die elektrische Baugruppe 21 umfasst eine Platine 22, auf der eine Anzahl elektrischer, insbesondere elektronischer, insbesondere Halbleiter-Bauelemente angeordnet ist. Anders als bei dem Ausführungsbeispiel gemäß FIG 1 befindet sich bei diesem Ausführungsbeispiel das Radar 25 jedoch direkt auf der zu überwachenden elektrischen Baugruppe 21. Es ist daher selbst von Verschmutzung betroffen, sodass sich auch auf einer Oberfläche eines Gehäuses 30 des Radars 25 Schmutz 24 befindet.

Auch das Radar 25 umfasst eine Radarsignalerzeugungseinrichtung in Form eines Signalprozessors 27, der ein Radarsignal 29 erzeugt, welches mittels einer Radarsignalsendeeinrichtung, insbesondere einer davon umfassten Sendeantenne 28, in Richtung eines in dem Gehäuse 30 des Radars 25 befindlichen, für das Radarsignal 29 transparenten Bereiches 31 des Gehäuses 30 ausgesendet wird.

Wie aus dem Ausführungsbeispiel gemäß FIG 2 ersichtlich, befindet sich (auch) in dem transparenten Bereich 31 des Gehäuses 30 der Oberfläche des Radars 25 Objekte in Form von Schmutz 24, an denen bzw. dem das Radarsignal 29 reflektiert wird. Das so entstandene reflektierte Radarsignal 32 (auch Empfangssignal oder "Echo" genannt) wird im Ausführungsbeispiel von mehreren Empfangsantennen 33, die Teil einer Radarsignalempfangseinrichtung sind, empfangen.

Die Radarsignalsendeeinrichtung und die Radarsignalempfangseinrichtung umfassen neben den bereits genannten Antennen in der Regel zumindest noch Signalwandler (nicht dargestellt), die das jeweilige Signal von einem elektrischen in ein elektromagnetisches Signal und umgekehrt wandeln.

Das Radar 25 umfasst weiterhin eine Radarsignalauswerteeinrichtung, die in dem Ausführungsbeispiel ebenfalls von dem Signalprozessor 27 umfasst ist und in der das von der Radarsignalempfangseinrichtung empfangene (reflektierte) Radarsignal ausgewertet wird zum Erkennen der bei der elektrischen Baugruppe 21 vorliegenden Verschmutzung in Form des Schmutzes 24.

Zum Erkennen einer Verschmutzung erfolgt auch hier vorzugsweise ein Vergleich mit in dem Signalprozessor 27 hinterlegten Daten, die zuvor anhand des nicht von Verschmutzung betroffenen Radars 25 gewonnen wurden.

Als weitere Besonderheit verfügt das Radar 25 gemäß dem Ausführungsbeispiel über mehrere an der Oberfläche des Gehäuses 30 angebrachte, voneinander beabstandete und nicht direkt elektrisch miteinander verbundene Elektroden 34, zwischen denen mittels der Spannungsquellen 35 eine elektrische Spannung angelegt werden kann. Mittels ebenfalls vorhandener Strommesser 36 können zwischen den Elektroden 34 vorhandene (Kriech-) Ströme erfasst und entsprechende Signale dem Signalprozessor 27 zur weiteren Signalanalyse zugeführt werden. Dadurch wird es möglich, bestimmte Eigenschaften des Schmutzes 24 näher zu bestimmen. Insbesondere ist es dadurch möglich, die elektrische Leitfähigkeit des Schmutzes 24 zu ermitteln. Dies ist besonders vorteilhaft, da elektrisch leitfähiger Schmutz 24 zu elektrischen Kurzschlüssen bei der elektrischen Baugruppe 21 führen kann, was eine Beschädigung bis hin zum Ausfall der elektrischen Baugruppe 21 nach sich ziehen könnte. Der Signalprozessor 27 kann diese Daten mit in die Signalanalyse einbeziehen und in Abhängigkeit davon geeignete Maßnahmen ableiten, zum Beispiel eine Warnmeldung erzeugen oder die elektrische Baugruppe 21 abschalten.

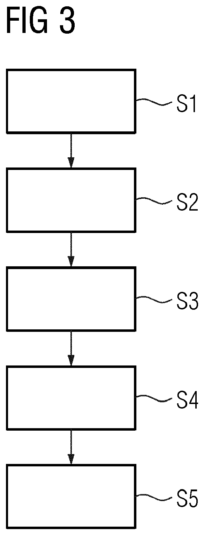

FIG 3 beschreibt nochmals die wesentlichen Verfahrensschritte bei der Durchführung eines erfindungsgemäßen Verfahrens zum Überprüfen einer elektrischen Baugruppe auf Verschmutzung mittels eines Radars.

In einem ersten Verfahrensschritt S1 wird mittels einer Radarsignalerzeugungseinrichtung, insbesondere einem Signalgenerator bzw. einem Signalprozessor, ein Radarsignal erzeugt.

In einem zweiten Verfahrensschritt S2 wird das in Verfahrensschritt 1 erzeugte Radarsignal mittels einer Radarsignalsendeeinrichtung, die wenigstens eine Sendeantenne zum Senden des erzeugten Radarsignals umfasst, in Richtung einer von der elektrischen Baugruppe umfassten Oberfläche ausgesendet. Anschließend wird das ausgesendete Radarsignal an der Oberfläche der elektrischen Baugruppe oder an wenigstens einem an der Oberfläche der elektrischen Baugruppe befindlichen Objekt, insbesondere Schmutz, reflektiert. Dabei hängt die Signalstärke des reflektierten Radarsignals bzw. dessen Phasenlage gegenüber dem gesendeten Radarsignal stark von der Art, Form und Beschaffenheit der Oberfläche der elektrischen Baugruppe bzw. des darauf befindlichen Objekts ab.

In einem dritten Verfahrensschritt S3 wird das reflektierte Radarsignal mittels einer Radarsignalempfangseinrichtung, die wenigstens eine Empfangsantenne zum Empfangen des reflektierten Radarsignals umfasst, empfangen.

In einem vierten Verfahrensschritt S4 wird das von der Radarsignalempfangseinrichtung empfangene, reflektierte Radarsignal einer Radarsignalauswerteeinrichtung zugeführt, die wenigstens einen Signalprozessor zum Auswerten dieses Signals umfasst zum Erkennen einer bei der elektrischen Baugruppe vorliegenden Verschmutzung.

In einem fünften Verfahrensschritt S5 wird von der Radarsignalauswerteeinrichtung gegebenenfalls ein Warnhinweis erzeugt, der einen Benutzer über eine festgestellte Verschmutzung der elektrischen Baugruppe informiert.

## Patentansprüche

1. Verfahren zum Überprüfen einer elektrischen Baugruppe (10, 21) auf Verschmutzung mittels eines Radars (1, 25), wobei
- eine Radarsignalerzeugungseinrichtung ein Radarsignal (29) erzeugt und mittels einer Radarsignalsendeeinrichtung in Richtung einer von der elektrischen Baugruppe (10, 21) umfassten Oberfläche aussendet,
- wobei das Radarsignal (29) an der Oberfläche oder einem auf der Oberfläche befindlichen Objekt reflektiert wird,
- wobei eine Radarsignalempfangseinrichtung ein reflektiertes Radarsignal (32) empfängt und wobei
- eine Radarsignalauswerteeinrichtung das von der Radarsignalempfangseinrichtung empfangene, reflektierte Radarsignal (32) auswertet zum Erkennen einer bei der elektrischen Baugruppe (10, 21) vorliegenden Verschmutzung.

2. Verfahren nach Anspruch 1, wobei mittels der Radarsignalauswerteeinrichtung ein Vergleich mit Referenzdaten der unverschmutzten Oberfläche der elektrischen Baugruppe (10, 21) erfolgt.

3. Verfahren nach Anspruch 1 oder 2, wobei das Radar (1, 25) als UWB-Radar, als Millimeter-Radar oder als Infrarot-Radar ausgebildet ist.

4. Verfahren nach einem der vorherigen Ansprüche, wobei das Radar einen in sich geschlossenen, integrierten Radar-IC umfasst.

5. Verfahren nach Anspruch 4, wobei das Radar-IC Sende- und/oder Empfangsantennen umfasst.

6. Verfahren nach einem der vorherigen Ansprüche, wobei das Radar (1, 25) nicht von der elektrischen Baugruppe (10, 21) umfasst ist.

7. Verfahren nach einem der Ansprüche 1 bis 5, wobei das Radar (1, 25) von der elektrischen Baugruppe (10, 21) umfasst ist.

8. Verfahren nach einem der vorherigen Ansprüche, wobei das Radar (1, 25) ein Gehäuse (30) mit einem bezüglich des erzeugten Radarsignals (29) durchlässigen Gehäusebereich umfasst.

9. Verfahren nach einem der vorherigen Ansprüche, wobei das Radar (25) Mittel zum Messen eines elektrischen Widerstandes an der Oberfläche des Radars (25) umfasst, womit eine Verschmutzung in Form einer leitfähigen Belegung erkannt wird.

10. Radar (1, 25) zum Überprüfen einer elektrischen Baugruppe (10, 21) auf Verschmutzung, umfassend:
- eine Radarsignalerzeugungseinrichtung zum Erzeugen eines Radarsignals (29),
- eine Radarsignalsendeeinrichtung zum Senden des Radarsignals (29) in Richtung einer von der elektrischen Baugruppe (10, 21) umfassten Oberfläche,
- eine Radarsignalempfangseinrichtung zum Empfangen eines in Folge des gesendeten Radarsignals (29) an der Oberfläche oder einem auf der Oberfläche befindlichen Objekt reflektierten Radarsignals (32),
- eine Radarsignalauswerteeinrichtung zum Auswerten des von der Radarsignalempfangseinrichtung empfangenen, reflektierten Radarsignals (32) und zum Erkennen einer bei der elektrischen Baugruppe (10, 21) vorliegenden Verschmutzung.

11. Radar (1, 25) nach Anspruch 10, ausgebildet als UWB-Radar, als Millimeter-Radar oder als Infrarot-Radar.

12. Radar nach einem der vorherigen Ansprüche, wobei das Radar einen in sich geschlossenen, integrierten Radar-IC umfasst oder als in sich geschlossener, integrierter Radar-IC ausgebildet ist.

13. Radar nach Anspruch 12, wobei das Radar-IC Sende- und/oder Empfangsantennen umfasst.

14. Radar (1, 25) nach einem der Ansprüche 10 bis 13, wobei das Radar (1, 25) nicht von der elektrischen Baugruppe (10, 21) umfasst ist.

15. Radar (1, 25) nach einem der Ansprüche 10 bis 13, wobei das Radar (1, 25) von der elektrischen Baugruppe (10, 21) umfasst ist.

16. Radar (1, 25) nach einem der vorherigen Ansprüche, wobei das Radar (1, 25) ein Gehäuse (30) mit einem bezüglich des erzeugten Radarsignals (29) durchlässigen Gehäusebereich umfasst.

17. Radar (1, 25) nach einem der vorherigen Ansprüche, umfassend Mittel zum Messen eines elektrischen Widerstandes an der Oberfläche des Radars (1, 25) zum Erkennen einer Verschmutzung in Form einer leitfähigen Belegung.
